# EUROPÄISCHE PATENTSCHRIFT

(11) **EP 3 186 950 B1**
(45) Veröffentlichungstag und Bekanntmachung des Hinweises auf die Patenterteilung: **19.09.2018**
(21) Anmeldenummer: 15747438.8
(22) Anmeldetag: 31.07.2015
(51) Int. Cl.: H04N 5/225

(54) **IMAGERMODUL FÜR EINE FAHRZEUG-KAMERA UND VERFAHREN ZU DESSEN HERSTELLUNG**
IMAGER MODULE FOR A VEHICLE CAMERA AND METHOD FOR THE PRODUCTION THEREOF
MODULE D'IMAGERIE POUR UNE CAMÉRA DE VÉHICULE AUTOMOBILE ET PROCÉDÉ DE FABRICATION DUDIT MODULE

(30) Priorität: 29.08.2014 DE 102014217295
(43) Veröffentlichungstag der Anmeldung: 05.07.2017
(73) Patentinhaber: Robert Bosch GmbH, 70442 Stuttgart (DE)
(72) Erfinder: REICHE, Martin, 71263 Weil Der Stadt (DE); SEGER, Ulrich, 71229 Leonberg-Warmbronn (DE); BRAUNE, Thomas, 75365 Calw (DE)
(86) Internationale Anmeldenummer: PCT/EP2015/067649
(87) Internationale Veröffentlichungsnummer: WO 2016/030130

(56) Entgegenhaltungen:
- JP-A- 2010 232 396
- US-A1- 2007 217 786
- US-B1- 6 410 415

## Beschreibung

### Stand der Technik

Ein Imagermodul für eine Fahrzeug-Kamera wird im Allgemeinen in einem Kameragehäuse, z. B. zusammen mit weiteren elektrischen Komponenten und einer Leiterplatte aufgenommen. Das Imagermodul weist hierbei bereits ein Objektiv, einen das Objektiv aufnehmenden Linsenhalter, eine Trägereinrichtung zum Aufnehmen und Kontaktieren des Bildsensors und den Bildsensor selbst auf. Bei Flip-Chip-Imagermodulen ist der Bildsensor über an seiner die sensitive Fläche aufweisenden Oberseite vorgesehene Kontaktmitteln, z. B. Stud-Bumps, kontaktiert und weist mit seiner sensitiven Fläche durch eine Ausnehmung der Trägereinrichtung zu dem Objektiv.

Hierzu kann der Linsenhalter z. B. auf einer starren Trägereinrichtung, z. B. einer Metallplatte (stiffener) befestigt werden, auf der eine flexible Leitereinrichtung, z. B. ein sogenannter Flexleiter, befestigt wird.

Weiterhin sind Linsenhalter in MID (molded interconnect device)-Technologie bekannt, die mittels passiver Galvanisierung Leiterbahnstrukturen aufweisen. Auf die Leiterbahnstrukturen wird mittels eines Flip-Chip-Verfahrens ein Bildsensor mechanisch aufgebracht und über Stud-Bumps kontaktiert. Die Stud-Bumps können auf dem Bildsensor mittels eines Reibschweißverfahrens aufgebracht werden.

Kontaktierungen des Bildsensors auf MID-Strukturen erfordern zum Teil jedoch aufwendige technische Realisierungen. Bei NCA-Flip-Chip-Verfahren wird eine elektrische Verbindung der Stud-Bumps zu den Leiterbahnen der MID-Flächen über einen auf die Lebensdauer des Produkts zu gewährleistenden Anpressdruck an der Stirnfläche des Stud-Bumps zur Auflagefläche der Leiterbahn gewährleistet. Hierbei ergeben sich technische Herausforderungen, insbesondere aus der Ebenheit des MID-Kunststoffkörpers, der Ebenheit und Rauheit der Leiterbahn und der mechanischen Belastbarkeit der Bahn auf hohen Druck, weiterhin bezüglich der Gleichmäßigkeit des Anpressdrucks im relevanten Temperaturbereich und über die Lebenszeit.

Eine Nachbearbeitung eines auf MID-Basis eingesetzten Kunststoffteils nach dem Spritzprozess ist im Allgemeinen nicht möglich, weil hierdurch flächig Galvanisierungskeime freigelegt werden. Auf der planarisierten Fläche eines MID-Kunststoffes ist dann kein strukturiertes Layout herstellbar.

ICA-Verfahren verwenden Leitkleber zur Kontaktierung; an der feinen Rasterung bzw. dem feinen Pitch des Bildsensors von z. B. etwa 100 µm können hier direkt jedoch Schwierigkeiten durch Kurzschlussrisiken auftreten. ACA-Verfahren verwenden Leitkleber mit geringerer Konzentration leitfähiger Partikel, die nur in verdichteten Bereichen elektrische Kontakte ausbilden; sie erfordern jedoch eine geringe Oberflächenrauigkeit und hohe Ebenheit der Fügepartner.

Die EP 1 081 944 B1 beschreibt eine Konstruktion aus einer Metallplatte mit einem vollflächig aufgeklebten Flexleiter sowie einem in Flip-Chip-Technik auf dem Flexleiter aufgebrachten Imager (Bildsensor).

Die US 2007/0217786 A1 zeigt ein Kameramodul mit einem Gehäuse, Linsen, einem Schaltungsträger und einem Bildsensor.

Die US 6,410,415 B1 offenbart ein Verfahren zur Kontaktierung von zwei elektrischen Leiterplatten mittels des flip chip Verfahrens und polymer bumps.

Die JP 2010 232 396 (A) zeigt ein Kameramodul mit einem unter einer Glasplatte angeordneten Bildsensor.

### Offenbarung der Erfindung

Die Erfindung ist in den unabhängigen Ansprüchen 1 und 11 definiert.

Das erfindungsgemäße Imagermodul und das Verfahren zu seiner Herstellung ermöglichen einige Vorteile:
Der Bildsensor wird in Flip-Chip-Technik, d. h. mittels an seiner die sensitive Fläche aufweisenden Oberfläche vorgesehenen Kontaktmittel kontaktiert, wobei der Bildsensor an einer flexiblen Leitereinrichtung kontaktiert wird, die an einem Kunststoff-Körper stoffschlüssig angebracht ist, das bereits den Linsenhalter darstellt bzw. die wesentlichen Teile des Linsenhalters aufweist. Somit weist der Kunststoff-Körper einen Tubusbereich zur Aufnahme des Objektivs und einen Befestigungsbereich auf, an dem die flexible Leitereinrichtung stoffschlüssig angebracht ist.

Hierbei kann der Kunststoffkörper insbesondere als Spritzgussteil ausgebildet sein, vorzugsweise mit der Spritzrichtung entsprechend der nachfolgend ausgebildeten optischen Achse. Dem liegt der Gedanke zugrunde, dass wesentliche funktionelle Teile des Imagermoduls, nämlich ein Tubusbereich zur Aufnahme des Objektivs und ein Befestigungsbereich als Spritzgussteil ausgebildet werden können, an dem eine flexible Leitereinrichtung bzw. ein Flexleiter direkt stoffschlüssig angebracht werden kann. Somit kann durch ein Spritzgussteil und eine auflaminierte flexible Leitereinrichtung mit einer Kunststoff-Matrix bzw. Kunststoff-Folie und in der Kunststoff-Folie aufgenommenen metallischen Leitungen bereits die Aufnahme sowohl des Objektivs als auch ein direktes Anbringen des Bildsensors in Flip-Chip-Technik über z. B. Stud-Bumps ermöglicht werden.

Erfindungsgemäß wird erkannt, dass eine Kontaktierung des Bildsensors über Stud-Bumps auf eine flexible Leitereinrichtung alleine schwierig ist, insbesondere wegen der Probleme der Haftung des Stud-Bumps auf der flexiblen Leitereinrichtung; daher wird ein, insbesondere elektrisch, nicht leitender Klebstoff (NCA; non conductive adhesive) in Klebstoffbereichen zwischen dem Bildsensor und der flexiblen Leitereinrichtung eingebracht, insbesondere um die Stud-Bumps herum. Vorzugsweise wird ein Klebstoff eingesetzt, der nachfolgend beim Aushärten schrumpft. Hierdurch wird eine Zugspannung zwischen dem Bildsensor und der flexiblen Leitereinrichtung ausgebildet, die den Stud bump gegen die flexiblen Leitereinrichtung drückt und somit eine gute Kontaktierung sicherstellt. Die ansonsten oftmals nachteilhafte Wirkung eines Klebstoffschrumpfes wird somit vorteilhafterweise zur Verbesserung der Kontaktierung ausgenutzt. Grundsätzlich sind jegliche Klebstoffe mit Schrumpf (Volumenverringerung) bei ihrer Aushärtung einsetzbar, z. B. auch Klebstoffe auf Epoxyd-Basis.

Somit wird eine einfache Herstellung mit relativ wenigen Herstellungsschritten und hoher Prozesssicherheit ermöglicht. Insbesondere gegenüber MID- Ausbildungen des Linsenhalters mit durch passive Galvanisierung auszubildenden Leiterbahnen ergeben sich einige Vorteile:
So ist das Kunststoffmaterial des Linsenhalters grundsätzlich frei wählbar, wobei es vorteilhafterweise durch ein Spritzgussverfahren herstellbar ist; diese Herstellung in einem Spritzgussverfahren stellt jedoch für Kunststoffmaterialien keine relevante Beschränkung dar. Gegenüber den speziellen Kunststoffmaterialien, die für MID-Verfahren erforderlich sind, um durch Laser-Ablation bzw. Laser- Schreiben Metallstrukturen freizulegen und eine nachfolgende passive Galvanisierung zu ermöglich, ergeben sich zum einen Kostenvorteile beim Material und zum anderen prozesstechnische Vorteile. Erfindungsgemäß kann insbesondere ein Kunststoff mit einer hohen Druckfestigkeit und/oder hohen Steifigkeit gewählt werden.

Die flexible Leitereinrichtung bzw. der Flexleiter kann zu seiner Oberseite hin das Kunststoffmaterial bzw. die Kunststofffolie und zur Unterseite hin zumindest bereichsweise freiliegende metallische Leitungen, z. B. aus gewalztem Kupfer aufweisen. Hierdurch kann die flexible Leitereinrichtung auf die Unterseite des Befestigungsbereichs des Kunststoffkörpers auflaminiert werden, d. h. durch lokales Aufweichen stoffschlüssig angebracht werden, eine Befestigung mittels Kleben ist somit nicht erforderlich. Ein Auflaminieren ist hierbei prozesstechnisch einfach und sicher zu gewährleisten. Durch das Auflaminieren werden auch die metallischen Leitungen nicht beeinträchtigt.

Die flexible Leitereinrichtung kann hierbei ein oder mehrere Lagen aus Leitern aufweisen. Durch mehrlagiges Layout kann eine Entflechtung der einzelnen Leiter erreicht werden.

Die plane und druckstabile Gegenfläche zur Aufbringung des Bildsensors in dem Flip-Chip-Verfahren wird durch z. B. Nachbearbeitung oder ein einzulegendes Einlegeteil mit definierter planer Unterseite ermöglicht.

Durch den Klebstoff mit Schrumpf bei der Aushärtung wird eine gute Kontaktierung zwischen Stud bump und der flexiblen Leitereinrichtung über die Lebenszeit ermöglicht.

Ein weiterer Vorteil liegt in der Möglichkeit, in den Spritzgusskörper ein oder mehrere Einlegeteile aufzunehmen. Die Einlegeteile können zum einen eine mechanische Stabilität erhöhen; insbesondere kann ein Einlegeteil auch mit einer planen Unterseite eine plane, druckfeste und geeignete Bezugsfläche für den Flexleiter im Bereich der Kontaktierung des Bildsensors bereitstellen, so dass hier ein festes, planes Flip-Chip-Gegenlager für den zu montierenden Bildsensor erreicht wird.

Weiterhin ermöglicht ein Spritzguss-Kunststoffkörper auch eine Nachbearbeitung seiner Unterfläche, ohne dass Probleme wie bei den spezifischen MID-Formkörpern auftreten, die eine mechanische Nachbearbeitung aufgrund ihrer speziellen Schichtstruktur nicht zulassen.

Das Einlegeteil ermöglicht weiterhin auch die Ausbildung einer Apertur mit schwarzer Kante um die optische Achse herum, um das Ausleuchtungsfeld der aktiven Fläche des Bildsensors scharf zu begrenzen.

Weiterhin kann das Einlegeteil vorgesehen sein, um eine Entwärmung des Bildsensors zu ermöglichen. Somit kann das Einlegeteil z. B. auch metallisch sein und sich durch das Kunststoffteil nach außen erstrecken, um hier z. B. an einem metallischen Kammergehäuse angebunden zu werden.

### Kurze Beschreibung der Zeichnungen

- Fig. 1: zeigt ein Imagermodul für eine Fahrzeug-Kamera gemäß einer ersten Ausführungsform im Schnitt durch die optische Achse;
- Fig. 2: eine entsprechende Darstellung gemäß einer weiteren Ausführungsform; und
- Fig. 3: eine Detailvergrößerung aus Fig. 1 und 2.

### Beschreibung der Ausführungsformen

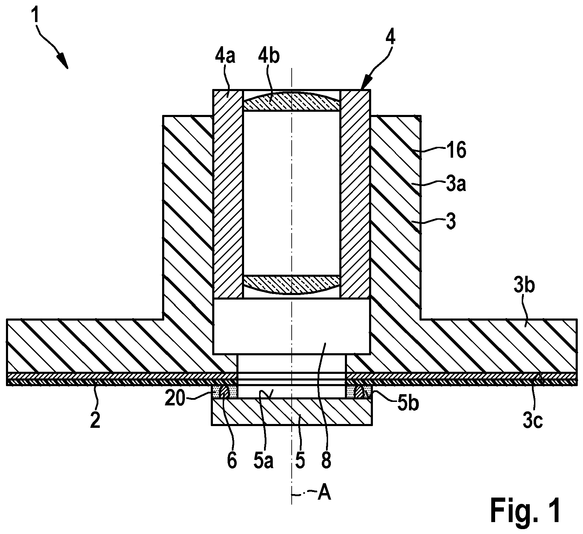

Ein Imagermodul 1 ist insbesondere zum Einsatz in einer Fahrzeug-Kamera vorgesehen und weist gemäß Fig. 1 eine Trägereinrichtung 2, einen Linsenhalter 3 (Objektivaufnahme), ein Objektiv 4 und einen Bildsensor 5 (Imager-Chip) auf. Das Imagermodul 1 wird im Allgemeinen nachfolgend in ein Kameragehäuse mit z. B. weiteren elektrischen oder elektronischen Komponenten aufgenommen und im Kfz-Bereich, vorzugsweise in dem Innenraum eines Fahrzeugs aufgenommen.

Das Objektiv 4 weist eine Linsenfassung 4a und in der Linsenfassung 4a aufgenommen Linsen 4b auf und ist zur Fokusierung entlang der Richtung einer optischen Achse A in einem Tubusbereich 3a des Linsenhalters 3 längsverschiebbar aufgenommen; das Imagermodul 1 ist vorteilhafterweise als Fix-Fokus-Modul mit nach erfolgter Fokussierung fixiertem Objektiv 4 ausgebildet, wobei die Fixierung z. B. durch einen Klebstoff oder z. B. auch eine Presspassung erfolgen kann. Der Linsenhalter 3 weist weiterhin einen Befestigungsbereich 3b auf, an dessen in Fig. 1 unteren Seite die Trägereinrichtung 2 mit ihrer Oberseite 2a befestigt ist.

Der Bildsensor 5 ist mittels Stud-Bumps 6 an einer Unterseite 2b der Trägereinrichtung 2 montiert und kontaktiert und weist mit seiner sensitiven Fläche 5a durch eine in der Trägereinrichtung 2 ausgebildete Ausnehmung 8 zu dem Objektiv 4, d. h. in Aufnahmerichtung nach vorne. Somit ist der Bildsensor 5 in Flip-Chip-Technik an der Trägereinrichtung 2 montiert.

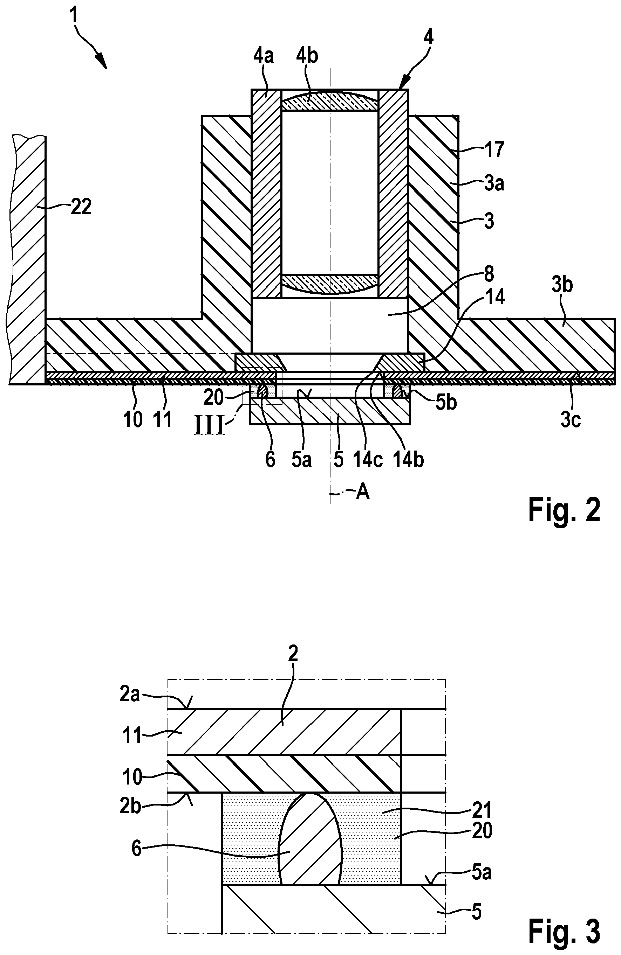

Die Trägereinrichtung 2 ist insbesondere in Fig. 3 detaillierter gezeigt und weist metallische Leitungen 10, vorzugsweise aus gewalztem Kupfer, eingebettet in einer Kunststoffmatrix 11, z. B. einer Kunststoff-Folie oder dünnen, flexiblen Kunststoffplatte auf. Das Kunststoffmaterial kann z. B. Polyimid sein. Die Trägereinrichtung 2 ist somit als flexible Leiteinrichtung bzw. Flexleiter ausgebildet. Die flexible Leitereinrichtung 2 ist mit ihrer Oberseite 2a auf dem Befestigungsbereich 3b des Linsenleiters 3 auflaminiert, d. h. durch lokales Aufschmelzen stoffschlüssig verbunden. Der Bildsensor 5 ist über die Stud-Bumps 6 mit den metallischen Leitern 10 der flexiblen Leitereinrichtung 2 kontaktiert.

Die metallischen Leitungen 10, z. B. Kupferleitungen 10, liegen vorteilhafterweise zur Unterseite 2b der flexiblen Leitereinrichtung frei, um hier eine direkte Kontaktierung des Bildsensors 5 über die Stud-Bumps 6 zu ermöglichen.

Um die Stud-Bumps 6 herum sind Klebstoffbereiche 20 ausgebildet, in denen ein nicht leitfähiger Klebstoff 21 (NCA) eingebracht ist, der eine Schrumpfung bzw. Volumenverringerung beim Aushärten erfährt. Die Klebstoffbereiche 20 erstrecken sich somit von der Oberseite 5a des Bildsensors bis zu der Unterseite 2b der flexiblen Leitereinrichtung 2, d.h. sie kleben den Bildsensor 5 an die flexible Leitereinrichtung 2. Hierdurch wird eine Zugspannung bewirkt, die die Stud-Bumps 6 gegen die Unterseite 2b der flexiblen Leitereinrichtung 2 drückt.

Der Kunststoffkörper 16 der Ausführungsform der Fig. 1 kann insbesondere an der Unterseite 3c, zumindest im Bereich um die optische Achse A herum nachbearbeitet werden, um hier eine plane Bezugsfläche für die flexible Leitereinrichtung 2 auszubilden, um hier ein Flip-Chip-Gegenlager bzw. eine zum einen mechanisch stabile und zum anderen definierte plane Bezugsfläche für die Flip-Chip-Montage des Bildsensors 5 auszubilden.

Bei der Ausführungsform der Fig. 2 hingegen wird diese plane Bezugsfläche durch ein Einlegeteil 14 erreicht. Das Einlegeteil 14 ist vorzugsweise ringförmig und konzentrisch zur optischen Achse A positioniert. Das Einlegeteil 14 kann z. B. aus Metall oder einem festen Kunststoff gebildet sein und erhöht die Steifigkeit des Linsenhalters 3, insbesondere im Bereich der Anbindung des Bildsensors 5; somit dient es als Gegenlager für das Aufbringen des Bildsensors 5 im Flip-Chip-Verfahren.

Das Einlegeteil 14 kann auch eine Hintergreifung oder Hinterschneidung des inneren Freiraumes des Tubusbereichs 3a des Linsenhalters 3 darstellen; somit wird durch das Einlegeteil 14 die Formgebung variabler gestaltet.

Das Einlegeteil 14 dient insbesondere auch als feste Unterlage der flexiblen Leitereinrichtung 2 im Bereich ihrer Aufnahme des Bildsensors 5. Hierzu weist das Einlegeteil 14 eine definierte, plane Einlegeteil-Unterseite 14b auf, die z. B. durch Nachbearbeitung festgelegt werden kann und als plane Bezugsfläche für die aufgebrachte flexible Leitereinrichtung 2 dient.

Das Einlegeteil 14 ermöglicht hierbei weitere Ausbildungen und Vorteile. So kann gemäß Fig. 2 das Einlegeteil zur optischen Achse A hin mit einer scharfen Kante 14c ausgebildet sein, dient somit als Apertur zur scharfen Begrenzung eines Ausleistungsfeldes der sensitiven Fläche 5a des Bildsensors 5. Somit werden die optischen Eigenschaften des Bildsensors 5 und des gesamten Imagermoduls 1 verbessert.

Das Einlegeteil 14 kann wie oben ausgeführt ringförmig an die optische Achse herumgelegt werden und somit lateral nach außen von dem Kunststoffkörper 17 umgeben sein. Es ist jedoch auch möglich, das Einlegeteil 14 mit größerer lateraler Erstreckung bzw. größerer Dimensionierung auszubilden. Hierbei kann das Einlegeteil 14 auch als Wärmesenke bzw. zur Entwärmung des Bildsensors 5 benutzt werden. Hierzu ist es auch vorteilhaft, das Einlegeteil gemäß der in Fig. 2 links gezeigten gestrichelten Ausbildung lateral nach außen vorzuführen, z. B. zur Kontaktierung an einem in Fig. 2 angedeuteten Kameragehäuse 22, so dass eine direkte Wärmeabfuhr nach außen ermöglicht ist.

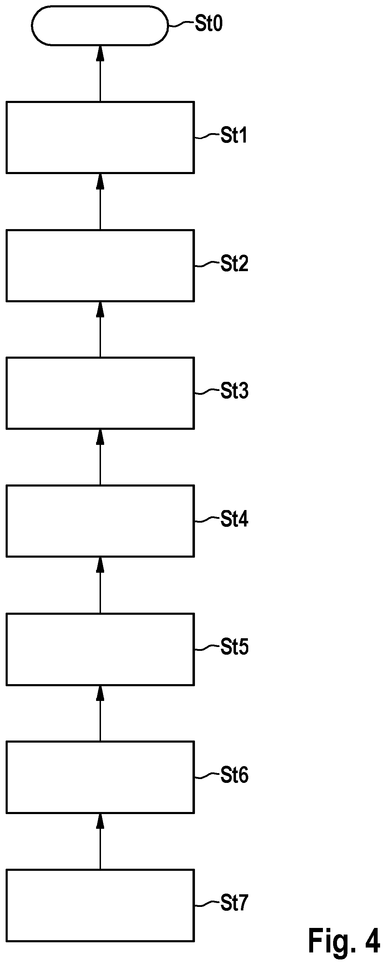

Das erfindungsgemäße Herstellungsverfahren weist somit vorteilhafterweise gemäß Fig. 4 folgende Schritte auf:
Nach dem Start des Schritts St0 wird in Schritt St1 der Flexleiter bzw. flexible Leitereinrichtung 2 ausgebildet durch Einbetten der metallischen Leitungen 10 in die Kunststoff-Matrix 11.

In Schritt St3 wird der Linsenhalter 3 in einem Spritzgussverfahren ausgebildet, wobei alternativ bereits in dem Schritt St2 das Einlegeteil 14 mit eingespritzt werden kann, d. h. in einem Spritzwerkzeug eingelegt und durch das Kunststoffmaterial des Linsenhalters 3 umspritzt werden kann; alternativ hierzu kann das Einlegeteil 14 nachfolgend wie gestrichelt in Fig. 4 gezeigt in den gespritzten Kunstkörper eingesetzt und vorzugsweise eingeklebt werden. In beiden Alternativen ist das Einlegeteil 14 stoffschlüssig in dem Kunststoffkörper des Linsenhalters 3 aufgenommen und befestigt.

Nachfolgend wird in Schritt St4 die flexible Leitereinrichtung 2 auf die Unterseite 3c des Befestigungsbereichs 3b auflaminiert, d. h. vorzugsweise durch lokales Aufschmelzen aufgeweicht und hierdurch Verschweißt bzw. formschlüssig verbunden.

Nachfolgend wird in Schritt St5 der Bildsensor 5 in Flip-Chip-Technik auf der Unterseite 2b der Flexleiter 2 positioniert und mittels der Stud-Bumps 6 mit den metallischen Leitungen 10 kontaktiert, wobei der Klebstoff 21 in den Klebstoffbereichen 20 eingebracht wird.

In Schritt St6 härtet nachfolgend der Klebstoff 21 aus, z. B. thermisch oder durch UV-Strahlung, oder auch als kalt abbindender Klebstoff nach seiner Aushärtzeit, unter Ausbildung der Zugspannung.

Nachfolgend kann dann - in an sich bekannter Weise - in Schritt St7 das Objektiv 4 von vorne (in den Figuren somit von oben) in den Tubusbereich 3a des Linsenhalters 3 in Axialrichtung A eingesetzt werden und mittels einer Fokussierung, z. B. durch Erfassen eines Testpatterns und Auswerten der Bildsignale des Bildsensors 5, eine Fokus-Position gefunden werden und das Objektiv 4 hierzu in dem Tubusbereich 3a fixiert werden, wodurch das Imagermodul 1 fertiggestellt ist.

## Patentansprüche

1. Imagermodul (1) für eine Fahrzeug-Kamera, wobei das Imagermodul (1) mindestens aufweist:
einen Linsenhalter (3),
ein in dem Linsenhalter (3) aufgenommenes Objektiv (4),
eine flexible Leitereinrichtung (2) mit Leitungen (10), und
einen mit den Leitungen (10) der flexiblen Leitereinrichtung (2) kontaktierten Bildsensor (5), der eine Vorderseite (5b) mit einer sensitiven Fläche (5a) aufweist,
wobei der Bildsensor (5) in Flip-Chip-Technik über an seiner Vorderseite (5b) vorgesehene Stud-Bumps (6) mit den Leitungen (10) kontaktiert ist,
wobei der Linsenhalter (3) einen Kunststoff-Körper (16, 17) mit einem Tubusbereich (3a) zur Aufnahme des Objektivs (4) und einem eine Unterseite (3c) aufweisenden Befestigungsbereich (3b) aufweist, die flexible Leitereinrichtung (2) auf der Unterseite (3c) des Befestigungsbereich (3b) stoffschlüssig angebracht ist, und
zwischen der Vorderseite (5b) des Bildsensors (5) und der flexiblen Leitereinrichtung (2) ein nicht-leitfähiger Klebstoff-Bereich (20) ausgebildet ist,
**dadurch gekennzeichnet, dass** die flexible Leitereinrichtung (2) metallische Leitungen (10) und eine Kunststoff-Matrix (11) aufweist, wobei die flexible Leitereinrichtung (2) mit ihrer Kunststoff-Matrix (11) an die Unterseite (3c) des Befestigungsbereichs (3b) durch Auflaminieren oder lokales Aufweichen aufgeschweißt ist.

2. Imagermodul (1) nach einem der vorherigen Ansprüche, **dadurch gekennzeichnet, dass** die flexible Leitereinrichtung (2) metallische Leitungen (10) in einer Kunststoff-Matrix (11) aufweist, wobei die metallischen Leitungen (10) zu einer Unterseite (2b) der flexiblen Leitereinrichtung (2) hin offen liegen, insbesondere wobei die flexible Leitereinrichtung (2) mehrere Lagen aus Leitern aufweist.

3. Imagermodul (1) nach einem der vorherigen Ansprüche, **dadurch gekennzeichnet, dass** die Stud-Bumps (6) in dem Klebstoff-Bereich (20) angeordnet sind.

4. Imagermodul (1) nach einem der vorherigen Ansprüche, **dadurch gekennzeichnet, dass** zwischen der Vorderseite (5b) des Bildsensors (5) und der flexiblen Leitereinrichtung (2) durch den Klebstoff-Bereich (20) eine Zugspannung ausgebildet ist, die die Stud-Bumps (6) gegen die Leitungen (10) der flexiblen Leitereinrichtung (2) drückt.

5. Imagermodul (1) nach einem der vorherigen Ansprüche, **dadurch gekennzeichnet, dass** der Kunststoff-Körper (16, 17) als Spritzgussteil (17) ausgebildet ist, wobei der Tubusbereich (3a) und der Befestigungsbereich (3b) Bereiche des Spritzgussteils (16, 17) sind.

6. Imagermodul (1) nach einem der vorherigen Ansprüche, **dadurch gekennzeichnet, dass** in dem Kunststoff-Körper (17) mindestens ein Einlegeteil (14) stoffschlüssig aufgenommen ist, wobei das Einlegeteil (14) zur Verstärkung der flexiblen Leitereinrichtung (2) im Bereich von Kontaktmitteln (6) zur Kontaktierung des Bildsensors (5) vorgesehen ist.

7. Imagermodul (1) nach Anspruch 6, **dadurch gekennzeichnet, dass** in der flexiblen Leitereinrichtung (2) eine Ausnehmung (8) ausgebildet ist, durch die die sensitive Fläche (5a) des Bildsensors (5) zu dem Objektiv (4) gerichtet ist, wobei das Einlegeteil (14) im Bereich der Ausnehmung (8) oder um die Ausnehmung (8) herum vorgesehen ist.

8. Imagermodul (1) nach Anspruch 6 oder 7, **dadurch gekennzeichnet, dass** das Einlegeteil (14) in das Spritzgussteil (17) eingespritzt ist.

9. Imagermodul (1) nach einem der Ansprüche 6 bis 8, **dadurch gekennzeichnet, dass** das Einlegeteil (14) eine radial zur optischen Achse hinweisende Kante (14c) zur Ausbildung einer Apertur für die sensitive Fläche (5b) des Bildsensors (5) aufweist.

10. Imagermodul (1) nach einem der Ansprüche 6 bis 9, **dadurch gekennzeichnet, dass** das Einlegeteil (14) metallisch ist und sich in dem Kunststoff-Körper (16, 17) radial durch den Befestigungsbereich (3b) nach außen erstreckt zur Anbindung an einem Kameragehäuse (22) zur Wärmeabfuhr des Bildsensors (5).

11. Verfahren zum Herstellen eines Imagermoduls (1) für eine Fahrzeug-Kamera, mit mindestens folgenden Schritten:
Herstellen einer flexiblen Leitereinrichtung mit einer Kunststoff-Matrix (11) und metallischen Leitungen (10) (St1),
Ausbilden eines Kunststoff-Körpers (16, 17) durch ein Spritzgussverfahren,
wobei der Kunststoff-Körper (16, 17) einen Tubusbereich (3a) und einen Befestigungsbereich (3b) mit einer Unterseite (3c) aufweist (St3),
Auflaminieren der flexiblen Leitereinrichtung (2) auf die Unterseite (3c) des Befestigungsbereich (3b) (St4),
Montieren und Kontaktieren des Bildsensors (5) in einer Flip-Chip-Technik mittels Stud-Bumps (6) auf einer Unterseite (2b) der flexiblen Leitereinrichtung (2) unter Kontaktierung mit den metallischen Leitungen (10) der flexiblen Leitereinrichtung (2) und Einbringung eines nicht-leitfähigen Klebstoffes (21) zwischen der Unterseite (2b) der flexiblen Leitereinrichtung (2) und dem Bildsensor (5) (St5),
Aushärten des nicht-leitfähigen Klebstoffes (21) unter Schrumpfung und Ausbildung einer Zugspannung zwischen der Unterseite (2b) der flexiblen Leitereinrichtung (2) und dem Bildsensor (5) (St6), und
Einsetzen eines Objektives (4) in den Tubusbereich (3a) des Linsenleiters (3) (St7).

12. Verfahren nach Anspruch 11, **dadurch gekennzeichnet, dass**
in dem Kunststoffkörper (17) ein Einlegeteil (14) mit einer planen Einlegeteil-Unterseite (14b) eingespritzt wird, und
die flexible Leitereinrichtung (2) um eine optische Achse (A) herum eine Ausnehmung (8) aufweist und am Rand der Ausnehmung (8) an der Unterseite (14b) des Einlegeteils (14) befestigt wird.

## Claims

1. Imager module (1) for a vehicle camera, wherein the imager module (1) at least has:
a lens element holder (3),
a lens (4) received in the lens element holder (3),
a flexible conductor device (2) having lines (10), and
an image sensor (5) contacted by the lines (10) of the flexible conductor device (2), said image sensor having a front side (5b) with a sensitive area (5a),
wherein the image sensor (5) by way of stud bumps (6) provided on its front side (5b) is contacted with the lines (10) in a flip-chip technique,
wherein the lens element holder (3) has a plastics body (16, 17) with a tubular region (3a) for receiving the lens (4) and a fastening region (3b) that has a lower side (3c), the flexible conductor device (2) being attached to the lower side (3c) of the fastening region (3b) in an integrally bonded fashion, and
a non-conductive adhesive region (20) is formed between the front side (5b) of the image sensor (5) and a flexible conductor device (2),
**characterized in that** the flexible conductor device (2) has metallic lines (10) and a plastics matrix (11), wherein the flexible conductor device (2) by way of its plastics matrix (11) is soldered onto the lower side (3c) of the fastening region (3b) by lamination or local softening.

2. Imager module (1) according to any one of the preceding claims, **characterized in that** the flexible conductor device (2) has metallic lines (10) in a plastics matrix (11), wherein the metallic lines (10) lie open to a lower side (2b) of the flexible conductor device (2), in particular wherein the flexible conductor device (2) has a plurality of layers of conductors.

3. Imager module (1) according to any one of the preceding claims, **characterized in that** the stud bumps (6) are arranged in the adhesive region (20).

4. Imager module (1) according to any one of the preceding claims, **characterized in that** a tensile stress, which presses the stud bumps (6) against the lines (10) of the flexible conductor device (2), is formed between the front side (5b) of the image sensor (5) and the flexible conductor device (2) by the adhesive region (20).

5. Imager module (1) according to any one of the preceding claims, **characterized in that** a plastics body (16, 17) is embodied as an injection moulded part (17), wherein the tubular region (3a) and the fastening region (3b) are regions of the injection moulded part (16, 17).

6. Imager module (1) according to any one of the preceding claims, **characterized in that** at least one insert part (14) is received in the plastics body (17) in an integrally bonded fashion, wherein the insert part (14) is provided for reinforcing the flexible conductor device (2) in the region of contact means (6) for contacting the image sensor (5).

7. Imager module (1) according to Claim 6, **characterized in that** a cut-out (8) is formed in the flexible conductor device (2), by means of which the sensitive area (5a) of the image sensor (5) is directed to the lens (4), wherein the insert part (14) is provided in the region of the cut-out (8) or around the cut-out (8).

8. Imager module (1) according to Claim 6 or 7, **characterized in that** the insert part (14) is injected into the injection moulded part (17).

9. Imager module (1) according to any one of Claims 6 to 8, **characterized in that** the insert part (14) has an edge (14c), pointing radially to the optical axis, for forming an aperture for the sensitive area (5b) of the image sensor (5).

10. Imager module (1) according to any one of Claims 6 to 9, **characterized in that** the insert part (14) is metallic and said insert part extends in the plastics body (16, 17) radially through the fastening region (3b) to the outside for the purposes of attachment to a camera housing (22) for dissipating heat from the image sensor (5).

11. Method for producing an imager module (1) for a vehicle camera, including at least the following steps:
producing a flexible conductor device having a plastics matrix (11) and metallic lines (10) (St1), forming a plastics body (16, 17) by way of an injection moulding method, wherein the plastics body (16, 17) has a tubular region (3a) and a fastening region (3b) with a lower side (3c) (St3),
laminating the flexible conductor device (2) onto the lower side (3c) of the fastening region (3b) (St4),
assembling and contacting the image sensor (5) in a flip-chip technique by means of stud bumps (6) on a lower side (2b) of the flexible conductor device (2) while contacting with the metallic lines (10) of the flexible conductor device (2) and introducing a non-conductive adhesive (21) between the lower side (2b) of the flexible conductor device (2) and the image sensor (5) (St5),
curing the non-conductive adhesive (21) under shrinkage and forming a tensile stress between the lower side (2b) of the flexible conductor device (2) and the image sensor (5) (St6), and
inserting a lens (4) into the tubular region (3a) of the lens element conductor (3) (St7).

12. Method according to Claim 11, **characterized in that** an insert part (14) with a plane insert part lower side (14b) is injected into the plastics body (17), and
the flexible conductor device (2) has a cut-out (8) around an optical axis (A) and said flexible conductor device is fastened to the edge of the cut-out (8) at the lower side (14b) of the insert part (14).

## Revendications

1. Module d'imagerie (1) pour une caméra d'un véhicule automobile, dans lequel le module d'imagerie (1) comprend au moins :
un support de lentille (3),
un objectif (4) logé dans le support de lentille (3),
un dispositif de circuit imprimé flexible (2) muni de lignes (10), et
un capteur d'image (5) qui est en contact avec les lignes (10) du dispositif de circuit imprimé flexible (2) et qui comporte une face avant (5a) ayant une surface sensible (5a),
dans lequel le capteur d'image (5) est mis en contact, selon une technique de puce retournée, avec les lignes (10) par l'intermédiaire de bosses de soudure (6) prévues sur sa face avant (5b),
dans lequel le support de lentille (3) comporte un corps en matière plastique (16, 17) ayant une zone en forme de tube (3a) pour le logement de l'objectif (4) et ayant une zone de fixation (3b) comprenant une face inférieure (3c), le dispositif de circuit imprimé flexible (2) étant appliqué par complémentarité de matériau sur la face inférieure (3c) de la zone de fixation (3b) et
une zone d'adhésif non conductrice (20) est formée entre la face avant (5b) du capteur d'image (5) et le dispositif de circuit imprimé flexible (2),
**caractérisé en ce que** le dispositif de circuit imprimé flexible (2) comporte des lignes métalliques (10) et une matrice en matière plastique (11), dans lequel le dispositif de circuit imprimé flexible (2) est soudé avec sa matrice de matière plastique (11) à la face inférieure (3c) de la zone de fixation (3b) par stratification ou par amollissement local.

2. Module d'imagerie (1) selon l'une des revendications précédentes, **caractérisé en ce que** le dispositif de circuit imprimé flexible (2) comporte des lignes métalliques (10) dans une matrice en matière plastique (11), dans lequel les lignes métalliques (10) sont ouvertes vers un côté inférieur (2b) du dispositif de circuit imprimé flexible (2), en particulier dans lequel le dispositif de circuit imprimé flexible (2) comporte plusieurs couches de conducteurs.

3. Module d'imagerie (1) selon l'une des revendications précédentes, **caractérisé en ce que** les bosses de soudure (6) sont disposées dans la zone d'adhésif (20).

4. Module d'imagerie (1) selon l'une des revendications précédentes, **caractérisé en ce qu'**une contrainte de traction est formée entre la face avant (5b) du capteur d'image (5) et le dispositif de circuit imprimé flexible (2) à travers la zone d'adhésif (20), qui comprime les bosses de soudure (6) contre les lignes (10) du dispositif de circuit imprimé flexible (2).

5. Module d'imagerie (1) selon l'une des revendications précédentes, **caractérisé en ce que** le corps en matière plastique (16, 17) est réalisé sous la forme d'une pièce moulée par injection (17), dans lequel la zone en forme de tube (3a) et la zone de fixation (3b) sont des zones de la pièce moulée par injection (16, 17).

6. Module d'imagerie (1) selon l'une des revendications précédentes, **caractérisé en ce qu'**au moins un insert (14) est logé par complémentarité de matériau dans le corps en matière plastique (17), dans lequel l'insert (14) est prévu pour renforcer le dispositif de circuit imprimé flexible (2) dans la zone de moyens de contact (6) destinés à être mis en contact avec le capteur d'image (5).

7. Module d'imagerie (1) selon la revendication 6, **caractérisé en ce qu'**un évidement (8) est formé dans le dispositif de circuit imprimé flexible (2), à travers lequel la surface sensible (5a) du capteur d'image (5) est dirigée vers l'objectif (4), dans lequel l'insert (14) est prévu dans la zone de l'évidement (8) ou autour de l'évidement (8).

8. Module d'imagerie (1) selon la revendication 6 ou 7, **caractérisé en ce que** l'insert (14) est injecté dans la pièce moulée par injection (17).

9. Module d'imagerie (1) selon l'une des revendications 6 à 8, **caractérisé en ce que** l'insert (14) présente un bord (14c) dirigé radialement vers l'axe optique pour former une ouverture pour la surface sensible (5b) du capteur d'image (5).

10. Module d'imagerie (1) selon l'une des revendications 6 à 9, **caractérisé en ce que** l'insert (14) est métallique et s'étend radialement vers l'extérieur dans le corps en matière plastique (16, 17) à travers la zone de fixation (3b) pour la liaison à un boîtier de caméra (22) afin de dissiper la chaleur du capteur d'image (5).

11. Procédé de fabrication d'un module d'imagerie (1) pour une caméra de véhicule, comprenant au moins les étapes consistant à :
fabriquer un dispositif de circuit imprimé flexible ayant une matrice en matière plastique (11) et des lignes métalliques (10) (St1),
réaliser un corps en matière plastique (16, 17) par un procédé de moulage par injection, dans lequel le corps en matière plastique (16, 17) comporte une partie en forme de tube (3a) et une zone de fixation (3b) ayant une face inférieure (3c) (St3),
stratifier le dispositif de circuit imprimé flexible (2) sur la face inférieure (3c) de la zone de fixation (3b) (St4),
monter et mettre en contact le capteur d'image (5), selon une technique de puce retournée, au moyen de bosses de soudure (6) sur une face inférieure (2b) du dispositif de circuit imprimé flexible (2) avec mise en contact avec les lignes métalliques (10) du dispositif de circuit imprimé flexible (2) et introduire un adhésif non conducteur (21) entre la face inférieure (2b) du dispositif de circuit imprimé flexible (2) et le capteur d'image (5) (St5),
durcir l'adhésif non conducteur (21) tout en réduisant et créant une contrainte de traction entre la face inférieure (2b) du dispositif de circuit imprimé flexible (2) et le capteur d'image (5) (St6), et
insérer un objectif (4) dans la zone en forme de tube (3a) du conducteur de lentille (3) (St7).

12. Procédé selon la revendication 11, **caractérisé en ce qu'**un insert (14) ayant une face inférieure d'insert plane (14b) est injecté dans le corps en matière plastique (17), et
**en ce que** le dispositif de circuit imprimé flexible (2) présente un évidement (8) autour d'un axe optique (A) et est fixé au bord de l'évidement (8) sur la face inférieure (14b) de l'insert (14).
